# EUROPEAN PATENT SPECIFICATION

(11) **EP 1 732 230 B1**
(45) Date of publication and mention of the grant of the patent: **27.11.2013**
(21) Application number: 06113465.6
(22) Date of filing: 03.05.2006
(51) Int. Cl.: H04B 1/036, H04B 1/38

(54) **Portable electronic device**
Tragbares elektronisches Gerät
Appareil portable électronique

(30) Priority: 09.06.2005 CN 200510077819
(43) Date of publication of application: 13.12.2006
(73) Proprietor: HTC Corporation, Taoyuan County 330 (TW)
(72) Inventor: Huang, Yi-Chang, Xindian City (TW); Lin, Yao-Chung, Xindian City (TW)
(74) Representative: 2K Patentanwälte Blasberg Kewitz & Reichel

(56) References cited:
- US-A1- 2004 130 869
- US-A1- 2004 132 503
- US-A1- 2005 136 967

## Description

### BACKGROUND

The invention relates to a portable electronic device, and more particularly to a portable electronic device with a heat-dissipation function.

When a portable electronic device (for example, a personal digital assistant or a cell phone) performs wireless network communication or other high energy-consumption operations, heat produced by chips moves to light-emitting elements, batteries or other electronic elements thereof via a circuit board, raising the temperature thereof. This damages electronic elements and shortens lifespan. Additionally, battery charging chips produce high temperatures during the battery charging and such high temperatures may explode batteries (particularly lithium battery).

US 2004 130869 A relates generally to heat transfer and heat dissipation techniques, and in particular but not exclusively, relates to removal of heat generated from a hand-held device, such as a portable computer. Heat is removed from a small hand-held portable computer by dissipating the heat from surfaces that are not typically held by the user during hand-held operation. The heat is dissipated from fins located at a rear underside casing of the portable computer. Heat-generating internal electronic components or their heat sinks are placed in close proximity to the fins. Heat may also be dissipated from the backside of the display screen. The dissipation of the heat allows the portable computer to operate at higher frequencies.

US 2005 136967 A relates to mobile terminal. A mobile terminal is provided that may conduct heat generated from a print circuit board when a mobile terminal is in operation to a wider area by use of a heat releasing member having excellent conductivity. This may release unpleasantness that a user feels when using the terminal by lowering a temperature of a key pad. The mobile terminal may include a main body including a plurality of key pads for receiving information from a user; a print circuit board mounted in the main body; a battery provided at the main body; a folder coupled to the main body; a display provided at the folder for displaying a text and other image information; a speaker unit provided at the folder; a microphone unit provided at the main body; and a heat releasing member for releasing heat generated from the print circuit board.

### SUMMARY

An embodiment of a portable electronic device comprises a housing, a circuit board, a heat-conduction structure and a heat-dissipation structure. The circuit board is disposed in the housing. The heat-conduction structure is disposed in the housing and contacts the circuit board. The heat-dissipation structure is disposed outside the housing and connected to the heat-conduction structure, wherein heat is transmitted from the circuit board, passing the heat-conduction structure and the heat-dissipation structure to be dissipated out of the housing.

The invention reduces inner temperature of the portable electronic device, increases the lifespan of chips and light -emitting elements, and prevents batteries from exploding.

### DESCRIPTION OF THE DRAWINGS

The invention will be more fully understood from the following detailed description and the accompanying drawings, given by the way of illustration only and thus not intended to limit the invention.
Fig. 1a is an exploded view of a portable electronic device of a first embodiment;
Fig. 1b shows an assembled portable electronic device of the first embodiment;
Fig. 2 is a sectional view of a circuit board and a heat-conduction structure of the first embodiment;
Fig. 3 shows heat dissipated out of the portable electronic device of the first embodiment;
Fig. 4a is an exploded view of a portable electronic device of a second embodiment;
Fig. 4b is a sectional view of a circuit board and a heat-conduction structure of the second embodiment;
Fig. 5a shows a portable electronic device of a third embodiment;
Fig. 5b is a sectional view of a circuit board and a heat-conduction structure of the third embodiment;
Fig. 5c shows heat dissipated out of the portable electronic device of the third embodiment.

### DETAILED DESCRIPTION

### First embodiment

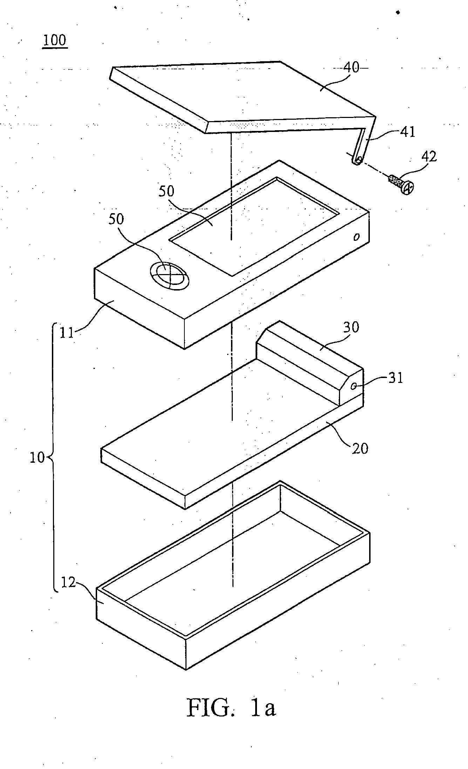

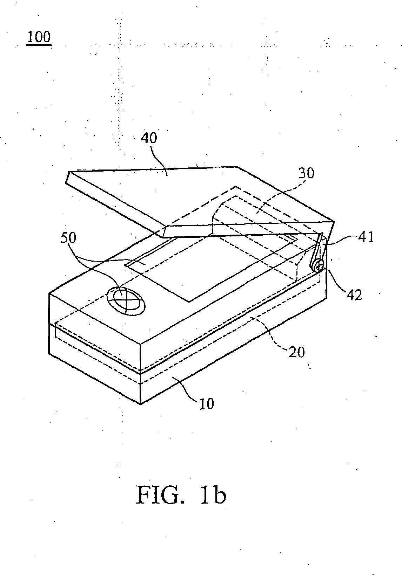

Fig. 1a is an exploded view of a portable electronic device 100 of the first embodiment, which comprises a housing 10, a circuit board 20, a heat-conduction structure 30, a heat-dissipation structure 40 and a control interface 50. The housing 10 comprises a first housing portion 11 and a second housing portion 12. The control interface 50 is disposed on the first housing portion 11. The circuit board 20 and the heat-conduction structure 30 are disposed in the housing 10. The heat-conduction structure 30 is disposed on the circuit board 20, comprising mounting holes 31. The heat-dissipation structure 40 is a cell phone cover comprising pivot portions 41. With reference to Fig. 1b, when the portable electronic device 100 is assembled, bolts 42 pass the pivot portions 41 and the housing 10 into the mounting holes 31 of the heat-conduction structure 30. The heat-dissipation structure 40 thus pivots on the heat-conduction structure 30.

In the disclosure, electronic elements (for example, chips and light-emitting elements) are not shown on the print circuit 20 to simplify description.

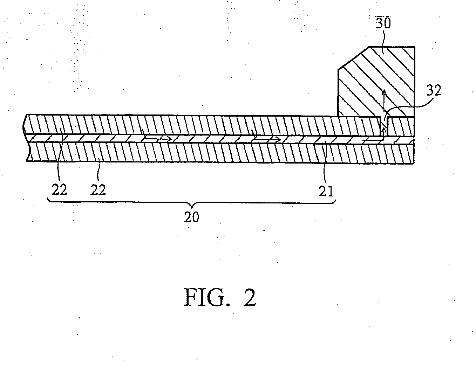

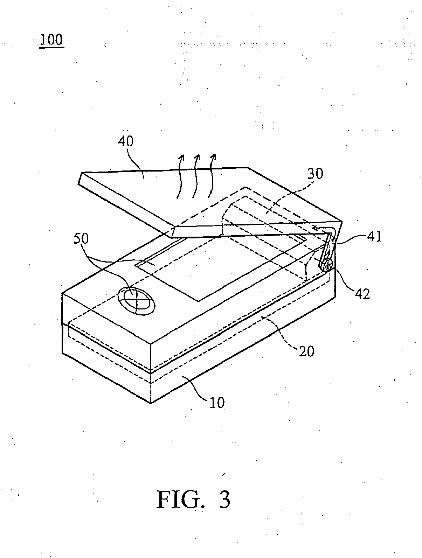

Fig. 2 is a sectional view of the circuit board 20 and the heat-conduction structure 30. The circuit board 20 comprises a heat-conduction layer 21 and substrates 22. The heat-conduction layer 21 made of copper and sandwiched between the substrates 22. The heat-conduction structure 30 comprises a protrusion 32 inserted into the circuit board 20 and contacting the heat-conduction layer 21. When the portable electronic device performs wireless network communication, battery charging or other heat-producing operations, heat produced by the electronic elements on the circuit board 20 passes the substrate 22, the heat-conduction layer 21 and the protrusion 32 to the heat-conduction structure 30. With reference to Fig. 3, heat is transmitted from the heat-conduction structure 30, passing the bolts 42 and the pivot portions 41 to the heat-dissipation structure 40 for dissipation. The heat-dissipation structure 40 is of metal, particularly copper. The inner temperature of the portable electronic device 100 exceeds the external temperature. Thus, the heat is continuously transmitted from the electronic elements, passing the substrate 22, the heat-conduction layer 21, the heat-conduction structure 30, the bolts 42 and the pivot portions 41 to the heat-dissipation structure 40 to be dissipated.

### Second embodiment

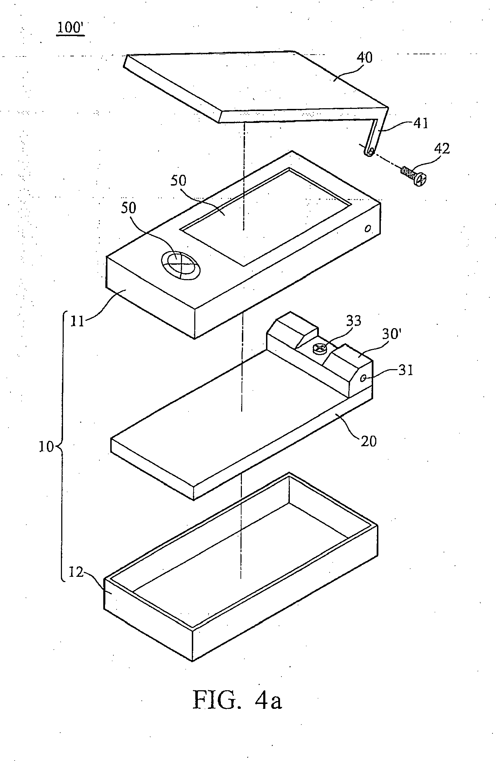

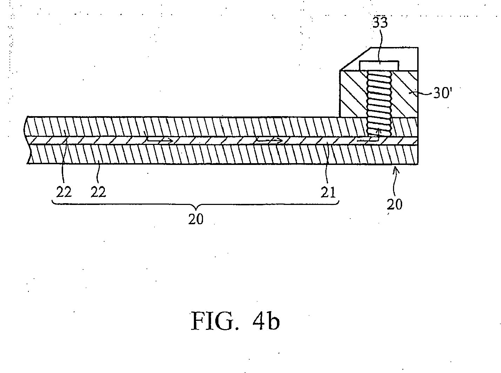

Fig. 4a is an exploded view of a portable electronic device 100' of a second embodiment, which differs from the first embodiment in the heat-conduction structure 30' being fixed on the circuit board 20 by bolt 33. With reference to Fig. 4b, the bolt 33 passes the substrate 22 and contacts the heat-conduction layer 21. Thus, heat produced by the electronic elements on the circuit board 20 passes the substrate 22, the heat-conduction layer 21 and the bolt 33 to the heat-conduction structure 30'.

Compared with the first embodiment, the second embodiment provides easier manufacturing and lower cost.

In the first and the second embodiments of the invention, the heat-dissipation structure 40 is a cell phone cover, but is not limited thereto. The heat-dissipation structure 40 can be a metal sheet disposed on a surface of the housing 10 or other structure.

### Third embodiment

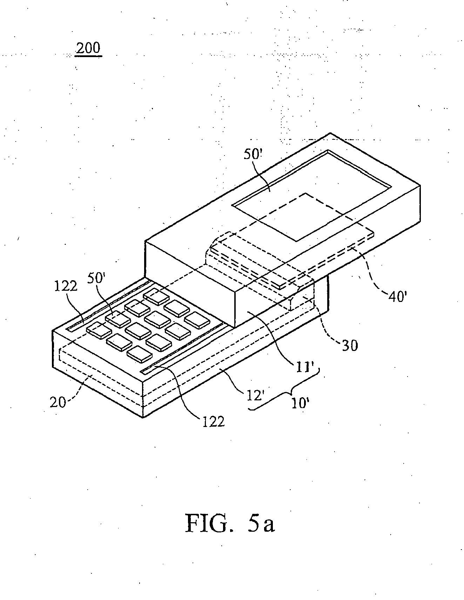

Fig. 5a shows a portable electronic device 200 of a third embodiment of the invention, which is a slide phone comprising a housing 10', a circuit board 20, a heat-conduction structure 30, a heat-dissipation structure 40' and control interface 50'. The control interface 50' is disposed on the housing 10'. The housing 10' comprises a sliding cover 11' and a body 12'. The body 12' comprises grooves 122 allowing the sliding cover 11' to slide thereon. The circuit board 20 and the heat-conduction structure 30 are disposed in the body 12'. The heat-dissipation structure 40' is a metal sheet disposed on the surface of the sliding cover 11'.

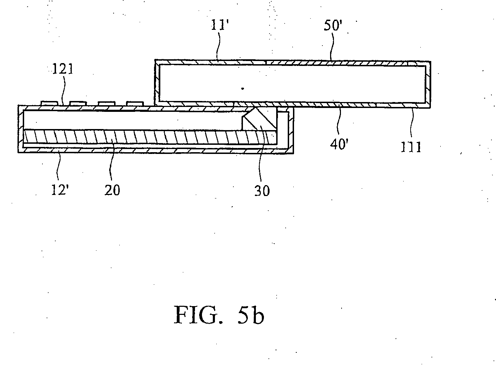

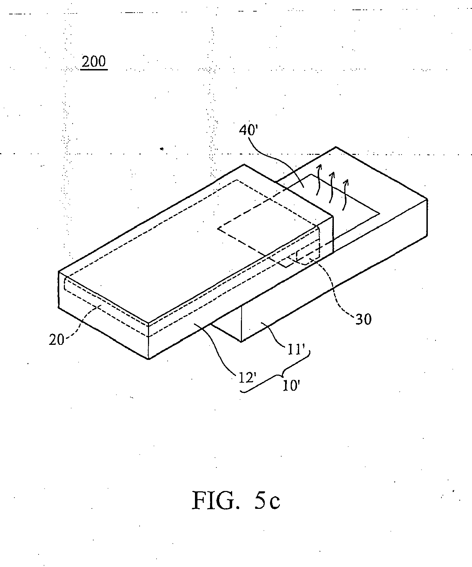

As shown in Fig. 5b, in the third embodiment, the top of the heat-conduction structure 30 is exposed on a first surface 121 of the body 12'. The heat-dissipation structure 40' is disposed on a second surface 111 of the sliding cover 11'. The top of the heat-conduction structure 30 directly contacts the heat-dissipation structure 40'. As shown in Fig. 5c, heat inside the portable electronic device 200 thus is transmitted to the heat-dissipation structure 40' to be dissipated.

In this embodiment, the portable electronic device 200 is a slide phone, but is not limited thereto. The portable electronic device 200 can be a rotating phone or other. The heat-dissipation structure 40' is not limited to disposition on the cover, and can be disposed on other locations on the portable electronic device 200.

While the invention has been described by way of example and in terms of preferred embodiment, it is to be understood that the invention is not limited thereto. To the contrary, it is intended to cover various modifications and similar arrangements (as would be apparent to those skilled in the art). Therefore, the scope of the appended claims should be accorded the broadest interpretation to encompass all such modifications and similar arrangements.

## Claims

1. A portable electronic device (100), comprising:
a housing (10);
a circuit board (20), disposed in the housing (10);
a heat-conduction structure (30), disposed in the housing (10) and contacted with the circuit board (20) for dissipating a heat from the circuit board (20), wherein the circuit board (20) comprises a heat-conduction layer (21) embedded in the circuit board (20) and contacted with the heat-conduction structure (30), and the heat-conduction layer (21) extends parallel to the circuit board (20) to transmit the heat parallel thereto, wherein the heat-conduction structure (30) comprises a protrusion (32) inserted into the circuit board (20) and contacted with the heat-conduction layer (21); and
a heat-dissipation structure (40), disposed outside the housing (10) and connected to the heat-conduction structure (30) for dissipating the heat out of the housing (10) from the heat-conduction structure (30), wherein the heat-dissipation structure (40) is a cell phone cover pivoting on the heat-conduction structure (30).

2. The portable electronic device as claimed in claim 1, wherein the heat-conduction structure (30) comprises metal.

3. The portable electronic device as claimed in claim 2, wherein the metal comprises copper.

4. The portable electronic device as claimed in claim 1, wherein the protrusion (32) is a bolt inserted into the circuit board (20), contacted with the heat-conduction layer (21), and fixed the heat-conduction structure (30) on the circuit board (20).

5. The portable electronic device as claimed in claim 1, wherein a material of the heat-conduction layer (21) comprises metal.

6. The portable electronic device as claimed in claim 5, wherein the metal comprises copper.

7. The portable electronic device as claimed in claim 1, wherein a material of the cell phone cover comprises metal.

8. The portable electronic device as claimed in claim 7, wherein the metal comprises copper.

9. A portable electronic device (100), comprising:
a housing (10'), comprising a sliding cover and a body, the sliding cover slidingly connecting the body;
a circuit board (20), disposed in the housing (10');
a heat-conduction structure (30), disposed in the housing (10') and contacted with the circuit board (20) for dissipating a heat from the circuit board (20), wherein the circuit board (20) comprises a heat-conduction layer (21) embedded in the circuit board (20) and contacted with the heat-conduction structure (30), and the heat-conduction layer (21) extends parallel to the circuit board (20) to transmit the heat parallel thereto, wherein the heat-conduction structure (30) comprises a protrusion (32) inserted into the circuit board (20) and contacted with the heat-conduction layer (21); and
a heat-dissipation structure (40'), disposed outside the housing (10) and contacted with the heat conduction structure for dissipating the heat out of the housing (10') from the heat-conduction structure (30), wherein the circuit board (20) and the heat-conduction structure (30) are disposed in the body, and the heat-dissipation structure (40') is disposed on a surface of the sliding cover.

10. The portable electronic device as claimed in claim 9, wherein a material of the heat-conduction structure (30) comprises metal.

11. The portable electronic device as claimed in claim 10, wherein the metal comprises copper.

12. The portable electronic device as claimed in claim 9, wherein the protrusion (32) is a bolt inserted into the circuit board (20), contacted with the heat-conduction layer (21), and fixed the heat-conduction structure (30) on the circuit board (20).

13. The portable electronic device as claimed in claim 9, wherein a material of the heat-conduction layer (21) comprises metal.

14. The portable electronic device as claimed in claim 13, wherein the metal comprises copper.

15. The portable electronic device as claimed in claim 1, wherein the combination of the protrusion and the heat-conduction structure is a single-piece structure.

16. **THE PORTABLE ELECTRONIC DEVICE AS CLAIMED IN CLAIM 9, WHEREIN THE COMBINATION OF THE PROTRUSION AND THE HEAT-CONDUCTION STRUCTURE IS A SINGLE-PIECE STRUCTURE.**

## Patentansprüche

1. Tragbares elektronisches Gerät (100), umfassend:
ein Gehäuse (10);
eine Leiterplatte (20), die in dem Gehäuse (10) angeordnet ist;
eine wärmeleitende Struktur (30), die in dem Gehäuse (10) angeordnet ist und die in Kontakt mit der Leiterplatte (20) steht, zum Ableiten von Wärme von der Leiterplatte (20), wobei die Leiterplatte (20) eine wärmeleitende Schicht (21) umfasst, die in der Leiterplatte (20) eingebettet ist und die in Kontakt mit der wärmeleitenden Struktur (30) steht, und die wärmeleitende Schicht (21) erstreck sich parallel zu der Leiterplatte (20), um die Wärme parallel dazu zu übertragen, wobei die wärmeleitende Struktur (30) einen Vorsprung (32) umfasst, der in die Leiterplatte (20) eingeführt ist, und in Kontakt mit der wärmeleitenden Schicht (21) steht, und
eine wärmeableitende Struktur (40), die außerhalb des Gehäuses (10) angeordnet ist und mit der wärmeleitenden Struktur (30) verbunden ist, zum Abführen der Wärme aus dem Gehäuse (10) von der wärmeleitenden Struktur (30), wobei die wärmeableitende Struktur (40) ein Mobiltelefon-Abdeckung ist, die drehbar/schwenkbar auf derwärmeleitenden Struktur (30) ist.

2. Tragbares elektronisches Gerät nach Anspruch 1, wobei die wärmeleitende Struktur (30) aus Metall besteht.

3. Tragbares elektronisches Gerät nach Anspruch 2, wobei das Metall Kupfer enthält.

4. Tragbares elektronisches Gerät nach Anspruch 1, wobei der Vorsprung (32) ein Bolzen ist, der in die Leiterplatte (20) eingefügt ist, mit der wärmeleitenden Schicht (21) in Kontakt steht, und die wärmeleitende Struktur (30) auf der Leiterplatte (20) fixiert.

5. Tragbares elektronisches Gerät nach Anspruch 1, wobei ein Material der wärmeleitenden Schicht (21) Metall umfasst.

6. Tragbares elektronisches Gerät nach Anspruch 5, wobei das Metall aus Kupfer umfasst.

7. Tragbares elektronisches Gerät nach Anspruch 1, wobei ein Material des Handy-Covers Metall umfasst.

8. Tragbares elektronisches Gerät nach Anspruch 7, wobei das Metall Kupfer umfasst.

9. Tragbares elektronisches Gerät (100), umfassend:
ein Gehäuse (10) mit einem Schlebedeckel und einen Körper, der Schiebedeckel ist gleitend mit dem Körper verbunden;
eine Leiterplatte (20), die in dem Gehäuse (10) angeordnet ist;
eine wärmeleitende Struktur (30), die in dem Gehäuse (10) angeordnet ist und in Kontakt mit der Leiterplatte (20) steht, zum Ableiten von Wärme von der Leiterplatte (20), wobei die Leiterplatte (20) eine wärmeleitende Schicht (21) umfasst, die In der Leiterplatte (20) eingebettet ist, und in Kontakt mit der wärmeleitendeh Struktur (30) steht und die wärmeleitende Schicht (21) erstreck sich parallel zu der Leiterplatte (20), um die Wärme parallel dazu zu übertragen, wobei die wärmeleitende Struktur (30) einen Vorsprung (32) umfasst, der in der Leiterplatte (20) eingeführt ist und in Kontakt mit der wärmeleitenden Schicht (21) steht, und
eine wärmeableitende Struktur (40), die außerhalb des Gehäuses (10) angeordnet ist und in Kontakt mit der wärmeleitenden Struktur steht, zum Abführen der Wärme aus dem Gehäuse (10), von der wärmeleitenden Struktur (30), wobei die Leiterplatte (20) und die wärmeleitende Struktur (30) in dem Körper angeordnet sind und die wärmeableitende Struktur (40) auf einer Oberfläche des Schlebedeckels angeordnet ist.

10. Tragbares elektronisches Gerät nach Anspruch 9, wobei ein Material der wärmeleitenden Struktur (30) Metall umfasst.

11. Tragbares elektronisches Gerät nach Anspruch 10, wobei das Metall Kupfer umfasst.

12. Tragbares elektronisches Gerät nach Anspruch 9, wobei der Vorsprung (32) ein Bolzen ist, der in die Leiterplatte (20) eingefügt ist, mit der wärmeleitenden Schicht (21) in Kontakt steht, und die wärmeleitende Struktur (30) auf der Leiterplatte (20) fixiert.

13. Tragbares elektronisches Gerät nach Anspruch 9, wobei ein Material der wärmeleitenden Schicht (21) Metall umfasst.

14. Tragbares elektronisches Gerät nach Anspruch 13, wobei das Metall Kupfer umfasst.

15. Tragbares elektronisches Gerät nach Anspruch 1, wobei die Kombination aus dem Vorsprung und der wärmeleitenden Struktur eine einteilige Struktur ist.

16. Tragbares elektronisches Gerät nach Anspruch 9, wobei die Kombination von dem Vorsprung und der wärmeleitenden Struktur eine einteilige Struktur ist.

## Revendications

1. Un dispositif électronique portable (100), comprenant :
un logement (10) ;
un circuit imprimé (20), disposé au sein du logement (10) ;
une structure conductrice de chaleur (30), disposée au sein du logement (10) et en contact avec le circuit imprimé (20) pour la dissipation de chaleur depuis le circuit imprimé (20), dans lequel le circuit imprimé (20) comporte une couche conductrice de chaleur (21) incorporée au circuit imprimé (20) et en contact avec la structure conductrice de chaleur (30), et la couche conductrice de chaleur (21) s'étendant parallèlement au circuit imprimé (20) pour une transmission de chaleur en parallèle, dans lequel la structure conductrice de chaleur (30) comporte une protubérance (32) insérée dans le circuit imprimé (20) et en contact avec la couche conductrice de chaleur (21) ; et
une structure de dissipation de chaleur (40), disposée à l'extérieur du logement (10) et en contact avec la structure conductrice de chaleur (30) pour la dissipation de chaleur depuis la structure conductrice de chaleur (30) vers l'extérieur du logement (10), dans lequel la structure de dissipation de chaleur est un couvercle de téléphone cellulaire pivotant sur la structure conductrice de chaleur (30).

2. Le dispositif électronique portable tel que revendiqué dans la revendication 1, dans lequel la structure conductrice de chaleur (30) est faite en métal.

3. Le dispositif électronique portable tel que revendiqué dans la revendication 2, dans lequel le métal comporte du cuivre.

4. Le dispositif électronique portable tel que revendiqué dans la revendication 1, dans lequel la protubérance (32) est un boulon inséré dans le circuit imprimé (20), en contact avec la couche conductrice de chaleur (21), et fixée à la structure conductrice de chaleur (30) sur le circuit imprimé (20).

5. Le dispositif électronique portable tel que revendiqué dans la revendication 1, dans lequel un matériau de la couche conductrice de chaleur (21) comporte du métal.

6. Le dispositif électronique portable tel que revendiqué dans la revendication 5, dans lequel le métal est du cuivre.

7. Le dispositif électronique portable tel que revendiqué dans la revendication 1, dans lequel un matériau du couvercle du téléphone cellulaire comporte du métal.

8. Le dispositif électronique portable tel que revendiqué dans la revendication 7, dans lequel le métal comporte du cuivre.

9. Un dispositif électronique portable (100), comprenant :
un logement (10'), comprenant un couvercle coulissant et un corps, le couvercle coulissant étant connecté de manière coulissante au corps ;
un circuit imprimé (20) disposé au sein du logement (10') ;
une structure conductrice de chaleur (30), disposée au sein du logement (10') et en contact avec le circuit imprimé (20) pour dissiper depuis le circuit imprimé (20) une chaleur, dans lequel le circuit imprimé (20) comporte une couche conductrice de chaleur (21) intégrée au circuit imprimé (20) et en contact avec la structure conductrice de chaleur (30), et la couche conductrice de chaleur (21) s'étendant parallèlement au circuit imprimé (20) pour une transmission de chaleur en parallèle, dans lequel la structure conductrice de chaleur (30) comporte une protubérance (32) insérée dans le circuit imprimé (20) et en contact avec la couche conductrice de chaleur (21) ; et
une structure de dissipation de chaleur (40'), disposée à l'extérieur du logement (10') et en contact avec la structure conductrice de chaleur pour la dissipation de chaleur depuis la structure conductrice de chaleur (30) vers l'extérieur du logement (10'), dans lequel le circuit imprimé (20) et la structure conductrice de chaleur (30) sont disposée au sein du corps, et la structure de dissipation de chaleur (40') est disposé sur une surface du couvercle coulissant.

10. Le dispositif électronique portable tel que revendiqué dans la revendication 9, dans lequel un matériau de la structure conductrice de chaleur (30) est en métal.

11. Le dispositif électronique portable tel que revendiqué dans la revendication 10, dans lequel le métal comporte du cuivre.

12. Le dispositif électronique portable tel que revendiqué dans la revendication 9, dans lequel la protubérance (32) est un boulon inséré dans le circuit imprimé (20), en contact avec la couche conductrice de chaleur (21), et fixée à la structure conductrice de chaleur (30) sur le circuit imprimé (20).

13. Le dispositif électronique portable tel que revendiqué dans la revendication 9, dans lequel un matériau de la couche conductrice de chaleur (21) est métallique.

14. Le dispositif électronique portable tel que revendiqué dans la revendication 13, dans lequel le métal est du cuivre.

15. Le dispositif électronique portable tel que revendiqué dans la revendication 1, dans laquelle la combinaison de la protubérance et de la structure conductrice de chaleur est une structure à pièce unique.

16. Le dispositif électronique portable tel que revendiqué dans la revendication 9, dans laquelle la combinaison de la protubérance et de la structure conductrice de chaleur est une structure à pièce unique.
